Europäisches Patentamt

European Patent Office

Office européen des brevets

(11) Numéro de publication: **0 220 677**
**B1**

(12) **FASCICULE DE BREVET EUROPEEN**

(45) Date de publication du fascicule du brevet: **11.07.90**

(51) Int. Cl.⁵: **H 05 K 7/14, H 01 R 23/68**

(21) Numéro de dépôt: **86114692.6**

(22) Date de dépôt: **23.10.86**

(54) **Ensemble d'interconnexion de cartes de circuits imprimés orthogonales et réseaux de commutation en faisant application.**

(30) Priorité: **25.10.85 FR 8515893**

(43) Date de publication de la demande:
**06.05.87 Bulletin 87/19**

(45) Mention de la délivrance du brevet:
**11.07.90 Bulletin 90/28**

(84) Etats contractants désignés:
**BE DE FR GB IT LU NL SE**

(56) Documents cités:
**DE-A-2 214 678**
**FR-A-2 109 246**
**GB-A-2 025 736**
**US-A-4 472 765**

(73) Titulaire: **ALCATEL CIT**
**12 Rue de la Baume**
**F-75008 Paris (FR)**

(72) Inventeur: **Petit, André**
**12, Clos des Maraîchers Longpont sur Orge**
**F-91310 Montlhery (FR)**
Inventeur: **Penicaud, Etienne**
**9 Sente Castel**
**F-92370 Chaville (FR)**
Inventeur: **Le Coz, Gérard**
**21 rue de Payenneville**
**F-91530 Saint Cheron (FR)**
Inventeur: **Jamet, Daniel**
**9 Allée des Iris Hameaux de Villiers**
**F-91620 Nozay (FR)**

(74) Mandataire: **Weinmiller, Jürgen et al**
**Lennéstrasse 9 Postfach 24**
**D-8133 Feldafing (DE)**

Courier Press, Leamington Spa, England.

## Description

La présente invention porte sur un ensemble d'interconnexion de cartes de circuits imprimés orthogonales appartenant à deux empilages, respectivement. Elle porte également sur la constitution de réseaux de commutation à étages de sélection en cascade, mettant en oeuvre un tel ou de tels ensembles d'interconnexion, ces réseaux de commutation rentrant dans des réseaux de télécommunication, en particulier dans les réseaux téléphoniques de transmission de données numériques à haut débit, par exemple à 45 Mbit/s.

un mode de connexion de cartes orthogonales est décrit, par exemple, dans le document US-A-4472765.

Un autre mode d'interconnexion de cartes orthogonales est décrit notam ment dans le document FR-A 2109 246.

Il permet l'interconnexion d'étages de sélection successifs de réseaux de commutation, en particulier de réseaux à trois étages de sélection en cascade, chacun défini par un empilage de cartes de circuits imprimés convenablement équipées.

Selon ce document, pour l'interconnexion de cartes de circuits imprimés orthogonales appartenant à deux empilages définissant deux étages de sélection successifs dans un réseau de commutation, on prévoit de placer les entrées et sorties de chaque carte sur un même bord dans leur empilage. Dans les deux empilages ces bords sont en vis-à-vis et les cartes de l'un des empilages sont disposées orthogonalement aux cartes de l'autre empilage. L'interconnexion entre ces étages de sélection est réalisée par simple enfichage en faisant coopérer des éléments de contact connectés aux différentes entrées et sorties de chacune des cartes des deux empilages. Ces éléments de contact sont des éléments hermaphrodites ou peuvent être, pour les cartes de l'un des empilages, des éléments de contact mâles et, pour celles de l'autre empilage, des éléments de contact femelles. Ce mode d'interconnexion permet de supprimer tout câblage entre les cartes des deux empilages.

Dans les exemples de réalisation décrits dans ce document, les éléments de contact sont montés par paires et sont, pour chacune des paires, placés sur les faces opposées de chaque carte concernée. L'interconnexion d'étages de sélection successifs, selon le mode d'interconnexion, nécessite l'adoption d'un même module d'écartement entre cartes et éléments de contact. Ainsi, dans la mesure où l'épaisseur des cartes est inférieure à la distance séparant deux éléments de contact placés sur une même face, on rapporte une cale de rattrapage convenable sur l'une des faces des cartes. Un tel rattrapage réalisé sur des cartes de circuits imprimés est très peu pratique et met en cause une industrialisation du mode d'interconnexion. En outre les liaisons électriques établies et la tenue mécanique de ces liaisons, au niveau de ces éléments de contact, semblent peu fiables.

Selon ce même document, dans un réseau de commutation à trois étages de sélection en cascade, utilisant ce mode d'interconnexion entre deux étages successifs, on dispose les cartes des deux étages de sélection extrêmes parallèlement les unes aux autres et perpendiculairement aux cartes de l'étage de sélection intermédiaire. Avantageusement, les cartes des deux étages extrêmes sont profilées en L de manière à porter, d'un même côté, les éléments de contact d'interconnexion avec les cartes de l'étage intermédiaire et des connecteurs de raccordement des cartes de ces étages extrêmes avec les circuits d'entrée (terminaux) et les circuits de sortie (joncteurs) à relier sélectivement. De cette manière, les connecteurs de raccordement sont à l'extérieur de l'étage de sélection intermédiaire et permettent de placer un répartiteur "en fond de panier".

La présente invention a pour but de réaliser un mode d'interconnexion entre cartes orthogonales supprimant également tout câblage entre les cartes et permettant, en outre, de réaliser simultanément les fonctions de distribution de signaux vers les différentes cartes, ceci en répondant aux exigences de fiabilité des liaisons établies et à celles d'industrialisation de l'ensemble d'interconnexion et des réseaux de commutation en résultant.

Elle a donc pour objet un ensemble d'interconnexion de cartes de circuits imprimés orthogonales d'un premier empilage et d'un second empilage, respectivement, comportant des premiers éléments de contact montés sur les bords en vis-à-vis desdites cartes dans leurs deux empilages et affectés aux liaisons entre cartes, et une carte de circuits imprimés supplémentaire, dite carte d'interface, montée perpendiculairement auxdites cartes entre les deux empilages, caractérisé en ce qu'il comporte, en outre, des seconds éléments de contact montés sur les mêmes bords en vis-à-vis desdites cartes, et définissant avec lesdits premiers éléments de contact une série de premières prises multiples à enfichage le long du bord concerné de chacune desdites cartes du premier empilage et une série de secondes prises multiples à enfichage le long du bord concerné de chacune desdites cartes du second empilage, et en ce que ladite carte d'interface porte d'une part, un réseau de pistes conductrices affecté à la distribution de signaux auxdites cartes et dit réseau de distribution et, d'autre part, des troisièmes éléments de contact dits de liaison et des quatrièmes éléments de contact dits de distribution et reliés audit réseau de distribution, montés transversalement à ladite carte d'interface en définissant, sur une première de ses faces, un ensemble de troisièmes prises multiples d'enfichage desdites premières prises et, sur la deuxième de ses faces, un ensemble de quatrièmes prises multiples d'enfichage desdites secondes prises, assurant la connexion entre les premiers éléments desdites premières et secondes prises correspondantes à travers lesdits éléments de liaison et la connexion desdits seconds éléments de contact de chacune desdites cartes audit réseau de distribution à travers lesdits éléments de distribution.

Elle a également pour objet un réseau de commutation matriciel entre circuits bidirectionnels, à étages de sélection en cascade chacun défini par un empilage de cartes portant un circuit de commutation et dites de commutation, mettant en oeuvre ledit ensemble d'interconnexion entre cartes orthogonales de deux empilages ci-avant, caractérisé en ce que, pour un réseau à trois étages de sélection ayant une symétrie au niveau de l'étage central, chacune des cartes dudit premier empilage est affectée aux premier et troisième étages de sélection et porte, outre lesdites premières prises multiples, des accès bidirectionnels pour autant de couples de paires coaxiales qu'il y a de premières prises multiples, lesdits accès étant montés sous forme de connecteurs coaxiaux sur les bords de la carte considérée adjacents à celui portant lesdites premières prises.

Elle a aussi pour objet un réseau de commutation matriciel entre circuits bidirectionnels à étages de sélection en cascade chacun défini par un empilage de cartes portant un circuit de commutation et dites de commutation, mettant en oeuvre l'ensemble d'interconnexion entre cartes orthogonales de deux empilages ci-avant, caractérisé en ce que ledit ensemble d'interconnexion est utilisé entre des cartes de commutation constituant les cartes du premier empilage et appartenant aux étages d'extrémité du réseau et des cartes dites de jonction constituant les cartes du second empilage et traitant les circuits bidirectionnels auxquels sont affectées les cartes de commutation constituant le premier empilage.

Avantageusement, les prises portées par les cartes de jonction sont constituées dans des connecteurs mixtes, à broches et contacts coaxiaux, et les troisièmes et quatrièmes prises multiples portées par la carte d'interface de l'ensemble d'interconnexion dans des connecteurs mixtes complémentaires, à broches et contacts coaxiaux, montés sur la face en regard des cartes de jonction et ayant ses broches, autres que celles définissant lesdits éléments de liaison et de distribution, escamotées, les contacts coaxiaux sur ladite carte d'interface étant reliés aux circuits bidirectionnels.

Les caractéristiques et les avantages de la présente invention apparaîtront plus clairement dans la description qui suit d'exemples de réalisation illustrés dans les dessins ci-annexés. Dans ces dessins:

— la figure 1 représente une partie élémentaire d'un ensemble d'interconnexion entre cartes de circuits imprimés orthogonaux, selon l'invention,

— la figure 2 représente l'ensemble d'interconnexion résultant de la figure 1, permettant la constitution d'un réseau de commutation à trois étages de sélection en cascade,

— la figure 3 représente l'agencement selon la figure 2 monté en châssis,

— la figure 4 représente une partie élémentaire d'un ensemble d'interconnexion entre cartes de circuits imprimés orthogonales, selon une variante par rapport à la figure 1,

— les figures 5 et 6 représentent, vu de côté et en perspective, l'ensemble d'interconnexion résultant de la figure 4 et obtenu notamment à partir de connecteurs existants adaptés, cet ensemble d'interconnexion permettant la constitution d'un module d'extrémité dans un réseau de commutation, la figure 5 étant une vue selon la flèche V de la figure 6 et étant donnée avec des coupes de certains de ses éléments.

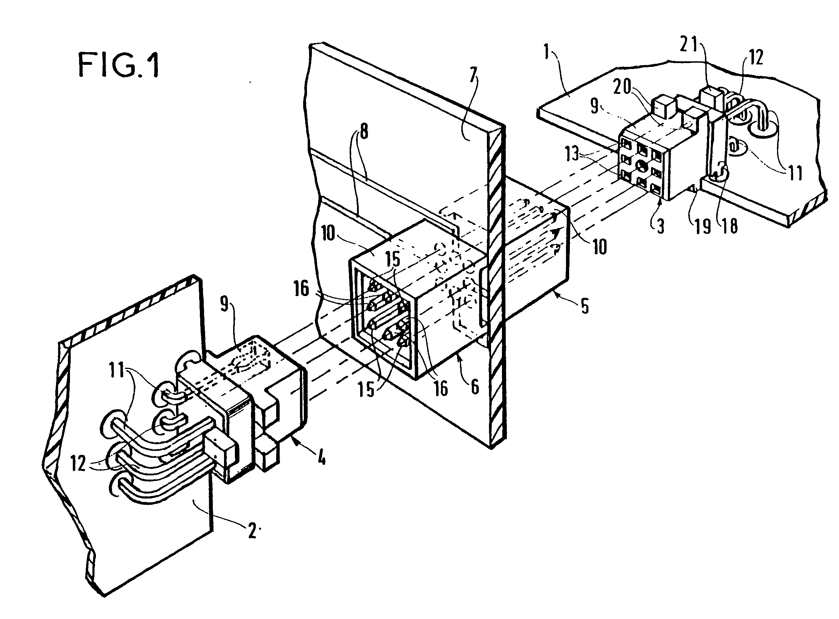

Dans la figure 1, on a représenté en perspective éclatée une partie élémentaire d'un ensemble d'interconnexion selon l'invention. Cette partie élémentaire concerne deux cartes de circuits imprimés orthogonales à interconnecter au niveau de leurs zones en vis-en-vis, l'une de ces cartes, 1, est horizontale l'autre, 2, est verticale; elles appartiennent en pratique à deux empilements de cartes verticales et horizontales.

Cette partie élémentaire de l'ensemble d'interconnexion comporte une première prise multiple 3 et une deuxième prise multiple 4, qui sont montées sur les bords en regard de l'une et de l'autre des cartes 1 et 2, au niveau des zones en vis-à-vis, et une troisième prise multiple 5 et une quatrième prise multiple 6 qui sont montées sur les deux faces opposées d'une carte de circuits imprimés supplémentaire 7, dite carte d'interface. Cette carte d'interface 7 porte en outre un réseau de pistes conductrices 8 sur l'une et/ou l'autre de ses faces.

La première et la deuxième prise multiple sont identiques l'une à l'autre. Chacune d'elles a une embase 9 formant le corps de la prise, ayant globalement la forme d'un parallélépipède de section carrée, et est positionnée sur l'une des faces de la carte concernée en faisant saillie sur le bord de cette carte. La troisième et la quatrième prise multiple sont également identiques l'une à l'autre. Elles sont dans le prolongement l'une de l'autre en étant transversales à la carte d'interface sur l'une et l'autre de ses deux faces respectivement. Chacune de ces prises 5 et 6 a une embase 10 parallélépipèdique de section carrée dans laquelle peut s'emboîter l'une ou l'autre des embases 9.

Cette partie élémentaire de l'ensemble d'interconnexion est destinée à permettre une connexion bidirectionnelle à deux fils pour chaque sens entre les cartes 1 et 2. A cet effet, la première et la seconde prise multiple, 3 et 4, ont chacune quatre premiers éléments de contact individuels, tels que 11. A l'intérieur de leur prise, ces quatre éléments de contact 11 sont isolés les uns des autres et occupent, vus en coupe, une disposition relative selon les quatre sommets d'un carré. Chacune de ces mêmes prises a, en outre, deux deuxièmes éléments de contact supplémentaires, tels que 12.

Ces deuxièmes éléments de contact, à l'intérieur de leur prise, sont isolés l'un de l'autre et des quatre premiers éléments et sont, vus en coupe, selon les milieux des côtés opposés du carré défini par les premiers éléments, les deux côtés opposés en cause étant ceux parallèles à la carte portant la prise.

Les six éléments de contacts tels que 11 et 12 sont partiellement montés dans l'embase 9. Cette embase présente huit logements internes identiques tels que 13, six d'entre d'eux recevant à force les six éléments de contact précités tels que 11 et 12 et assurant leur maintien et leur isolement, les deux autres selon les milieux des deux côtés opposés du carré défini restant libres. Dans l'embase 9, les extrémités des éléments de contact sont enléger retrait par rapport à la face frontale de la prise; ces extrémités dans l'embase se terminent chacune en forme de deux branches de contact à pression pour une broche individuelle, ainsi que schématisé pour l'un de ces éléments de contact, leurs logements constituant sur la face frontale de la prise des accès de guidage d'enfichage pour de telles broches.

Les extrémités de ces six éléments de contact tels que 11 et 12, extérieures à l'embase 9, sont coudées et reliées à la carte 1 ou 2, selon le cas. Ces extrémités sont disposées en deux rangées parallèles au bord de la carte 1 ou 2, sont insérées dans des trous métallisés prévus à leur effet et y sont soudées.

En correspondance avec l'une ou l'autre des prises 3 et 4, chacune des prises 5 et 6 a quatre troisièmes éléments de contact, tels que 15 et quatre quatrièmes éléments de contact, tels que 16. Ces éléments de contact 15 et 16 sont des broches individuelles communes pour les deux prises et isolées les unes des autres. Celles de ces broches formant les troisièmes éléments de contact de l'une et l'autre des prises 5 et 6 traversent simplement ces prises et la carte d'interface 7, celles formant les quatrièmes éléments de contact des prises traversent également les prises et la carte d'interface mais sont en outre reliées au réseau de pistes conductrices 8 de la carte d'interface 7.

Dans chacune des prises 5 et 6, les troisièmes éléments de contact 15 ont une disposition relative identique à celle des premiers éléments de contact de la prise 3 ou 4; ils s'enfichent chacun entre les deux branches du premier élément de contact correspondant de la prise 3 ou 4.

Vus en coupe, les quatrièmes éléments de contact 16 sont selon les milieux des côtés du carré défini par les troisièmes éléments; ils s'enfichent, pour deux opposés d'entre eux, entre les deux branches des deuxièmes éléments de contact de l'une des prises 3 et 4 et, pour les deux autres, entre les branches des deuxièmes éléments de contact de l'autre des prises 3 et 4.

Les broches des prises 5 et 6 sont montées à force dans des trous de la carte d'interface qu'elles traversent, ces trous étant métallisés en ce qui concerne les broches formant les quatrièmes éléments de contact, et reçoivent aussi à force chaque embase 10 qu'elles traversent également.

Dans les prises 5 et 6, les embases 10 entourent les parties terminales des broches et ainsi les protègent et assurent un guidage à l'enfichage des prises 3 et 4 à travers les faces frontales ouvertes des prises 5 et 6. La symétrie des deux prises 5 et 6 par rapport à la carte d'interface 7 permet le raccordement convenable indiqué ci-avant entre leurs éléments de contact et ceux des prises 3 et 4.

Pour le positionnement convenable des embases 9 des prises 3 et 4 sur les cartes 1 et 2, sur chaque embase 9 une nervure 19 est prévue en saillie sur sa face venant en appui contre la carte 1 ou 2, la nervure 19 venant elle-même en appui contre la tranche de la carte.

Pour un enfichage correct à fond de l'une des prises 3 et 4 dans l'une des prises 5 et 6, on prévoit sur la face de l'embase 9, opposée à la face portant la nervure 19, deux ergots tels que 20 faisant butée pour l'embase 10 en fin d'enfichage. Sur cette même face, un ergot supplémentaire 21 définit entre lui et les ergots 20 un logement pour une éventuelle bride de maintien, telle par exemple celle représentée dans cette figure 1 avec la référence 18.

Cette partie élémentaire constitue un module d'interconnexion. Elle assure une liaison bidirectionnelle possible entre les cartes 1 et 2 mais permet également, par les éléments de contact sur les milieux des côtés de la disposition en carré illustrée, la distribution de signaux d'alimentation, d'horloge, de commande et le prélèvement de signaux de test sur l'une et/ou l'autre des cartes 1 et 2 par la carte d'interface 7.

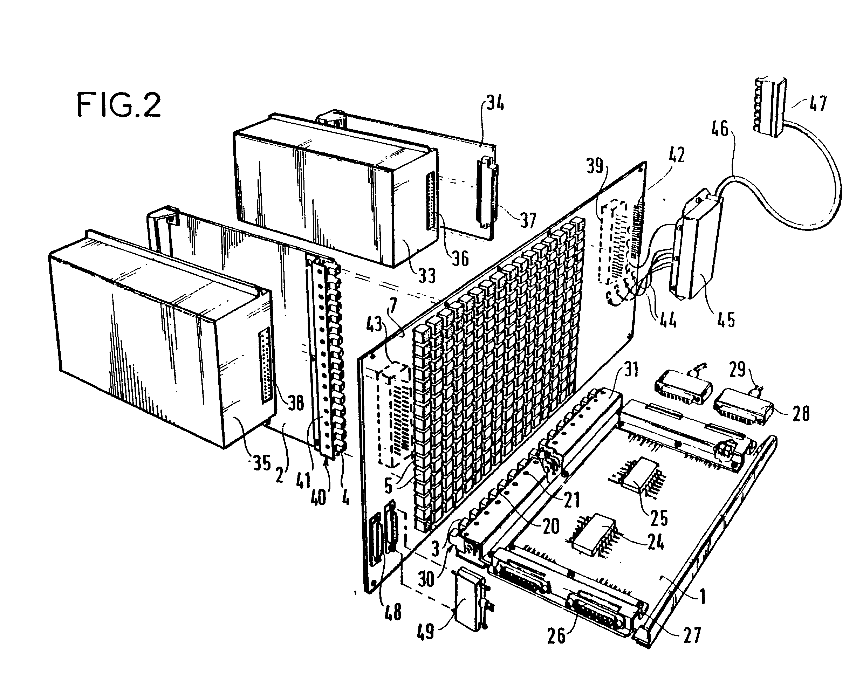

La figure 2 est une vue éclatée représentant l'agencement d'un réseau de commutation entre circuits entrants et circuits sortants, dans l'exemple considéré 256 circuits bidirectionnels. Ce réseau est de type matriciel organisé en étages de sélection en cascade. Il est, dans le cas de la répartition de 256 circuits bidirectionnels, à trois étages de sélection à matrices 16x16. Chacun des étages de sélection est réalisé par un empilage de cartes de circuits imprimés portant, chacune un circuit de raccordement avec un circuit de commutation matriciel inséré sur ce circuit de raccordement définissant des chemins de transmission possibles sur la carte, en ce qui concerne les cartes des deux étages extrêmes, entre des accès de circuits sur cette carte et des accès d'interconnexion entre cartes de deux étages de sélection adjacents et, en ce qui concerne les cartes de l'étage intermédiaire, entre des accès d'interconnexion entre cartes de deux étages de sélection adjacents. Pour l'interconnexion entre cartes de deux étages de sélection adjacents, ce réseau de commutation utilise un ensemble d'interconnexion formé de parties élémentaires identiques à celui de la figure 1.

En regard de la figure 2, le réseau de commutation affecté à 256 circuits bidirectionnels a une symétrie par rapport à l'étage de sélection central. Il comporte un premier étage de sélection constitué par un premier empilage de seize cartes, dites horizontales telles que la seule carte horizontale représentée et repérée par la référence 1 précitée, un deuxième étage de sélection constitué par un deuxième empilage de seize autres cartes, dites verticales, telle que la seule carte verticale représentée et repérée par la référence 2 précitée, et un troisième étage de sélection constitué par l'empilage des cartes horizontales telles que 1. Les cartes horizontales sont identiques entre elles, chacune d'elles appartient au premier étage de sélection et au troisième; les cartes verticales sont également identiques entre elles.

La carte horizontale 1 représentée porte deux circuits de commutation, illustrés en 24 et 25, affectés au premier étage de sélection et au troisième respectivement. La carte verticale 2 représentée ne porte qu'un circuit de commutation, non visible, affecté au deuxième étage de sélection.

Sur la carte horizontale 1 représentée, quatre connecteurs tels que 26, chacun équipé de huit contacts coaxiaux reliés au circuit de raccordement, non représenté, définissent seize accès bidirectionnels pour seize circuits bidirectionnels parmi les 256.

Ces connecteurs 26 sont montés sur deux côtés opposés de la carte 1, autres que celui en regard des cartes verticales, à raison de deux connecteurs côte à côte sur chaque côté. Ils sont fixés sur chacun de ces deux côtés, par un rail avantageusement métallique, profilé en U à bords rabattus, 27, qui les supporte et forme un raidisseur. Quatre fiches telles que 28 terminant quatre cordons de raccordement de huit paires coaxiales, 29, pour les seize circuits bidirectionnels, assurent les connexions par contact électrique de ces seize circuits bidirectionnels sur les accès bidirectionnels définis par les connecteurs 26 sur la carte 1.

Le bord de la carte 1, en vis-à-vis des cartes verticales, porte une réglette 30 de premières prises multiples identiques à la première prise multiple 3 de la figure 1 et désignées par cette référence 3. Cette réglette 30 est constituée par une série de seize prises 3 maintenues alignées et à pas régulier. Une glissière 31, profilée selon deux L à jambages verticaux confondus et dont l'un est renversé, assure cet alignement et ce maintien des prises 3 contre la carte 1. Cette glissière 31 a l'un de ses jambages horizontaux en appui contre les embases des prises 3, ce jambage présente des fenêtres dans lesquelles sont engagés les ergots 21 de la série de prises 3 et est maintenu par son bord contre les ergots 20. L'autre jambage horizontal de cette glissière s'appuie contre la carte 1 et y est fixé.

La carte verticale 2 porte, sur son bord en vis-à-vis des cartes horizontales, une autre réglette 40 de secondes prises multiples identiques à la seconde prise multiple 4 de la figure 1 et désignées par cette même référence. Cette réglette 40 est identique à la réglette 30; elle comporte ainsi une série de seize prises 4 alignées et à pas régulier maintenues par une glissière 41 identique à la glissière 31.

Dans la réglette 30, le pas des prises 3 est égal au pas des cartes verticales; dans la réglette 40, le pas des prises 4 est égal au pas des cartes horizontales. Ces pas sont identiques.

Dans ce réseau de commutation, une carte d'interface analogue à la carte d'interface 7 de la figure 1 assure l'interconnexion entre les cartes horizontales et verticales orthogonales des deux empilages qui sont équipées individuellement de leur réglette de prises. Cette carte d'interface est aussi désignée par la référence 7 précitée. Elle porte sur sa face en regard de l'empilage des cartes horizontales un ensemble de troisièmes prises multiples identiques à la prise 5 de la figure 1 et désignées par cette même référence 5. Elle porte sur son autre face en regard de l'empilage des cartes verticales un ensemble de quatrièmes prises multiples non visibles, qui sont toutes identiques à la prise 6 de la figure 1; cet ensemble de quatrièmes prises est identique à l'ensemble des troisièmes prises 5.

Dans l'ensemble des prises 5, les prises sont agencées de manière matricielle, en seize lignes et seize colonnes, en ayant entre elles sur chaque ligne ou colonne le même pas que celui entre les prises individuelles 3 ou 4 dans leur réglette 30 ou 40.

Ce réseau de commutation comporte aussi un convertisseur d'alimentation 33, un circuit de test et signalisation 34 et convertisseur de secours 35. Le convertisseur 33 et la carte de test et signalisation 34 sont disposés d'un côté de l'empilage des cartes verticales, telles que 2, le convertisseur de secours 35 est disposé de l'autre côté de cet empilage. Ils portent en regard de la carte d'interface 7 un connecteur mâle ou femelle, repéré en 36, 37 ou 38 selon l'élément concerné, enfichable dans un connecteur complémentaire porté par la carte d'interface et repéré en 39, 42 ou 43 en correspondance. Ces connecteurs sont de type connu. Les connecteurs portés par la carte d'interface 7 ont leurs broches insérées à force à travers la carte d'interface. Les deux connecteurs 39 et 42, affectés au bloc convertisseur 33 et à la carte de test et signalisation 34 qui sont côte à côte, ont leurs broches reliées également, du côté de l'empilage des cartes horizontales telles que 1, à des liaisons de sortie 44 d'un boîtier-filtre 45. Ce boîtier filtre 45 est lui-même connecté à une alimentation générale non représentée par un cordon d'alimentation et d'alarme 46 équipé d'une fiche terminale 47.

Un jeu de connecteurs supplémentaires, tels que 48, au voisinage du bord de la carte d'interface opposé à celui portant les connecteurs 39, 42, permet d'appliquer à la carte des signaux d'horloge et de commande. Ce jeu de connecteurs 48 reçoit ces signaux des connecteurs complémentaires 49 terminant des liaisons de transmission de ces signaux. Les alimentations et ces divers signaux d'horloge et de commande qui sont reçus par la carte d'interface sont distribués à chacune des cartes horizontales et verticales des deux empilages. Cette distribution est assurée par le réseau de pistes conductrices porté par la carte d'interface, comme dans la figure 1 mais non représenté dans la figure 2 pour éviter des surcharges, et par les quatrièmes éléments de contact des prises portées par la carte d'interface, qui définissent trente deux points d'accès pour la distribution de signaux distincts possibles le long du bord de chacune des cartes horizontales et verticales, telles que 1 et 2.

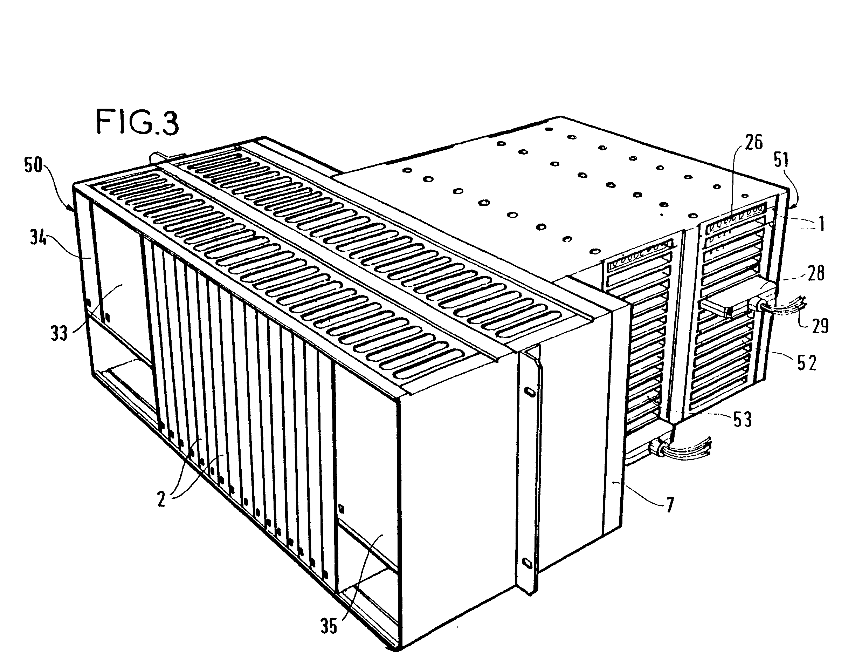

Dans la figure 3 on a représenté le réseau de commutation selon la figure 2 monté en châssis. Ce châssis a des dimensions compatibles avec les normes du CCITT. Les éléments qui y sont montés sont désignés par leurs références précédentes.

Ce châssis comporte une partie, dite avant, 50 ayant un compartiment central non référencé dans lequel sont logées les seize cartes verticales 2. Dans cette partie avant, des compartiments latéraux non référencés reçoivent d'une part le bloc convertisseur d'alimentation 33 et la carte de test et signalisation 34, séparément l'un de l'autre, et d'autre part le bloc convertisseur d'alimentation de secours 35. Dans ce châssis, une seconde partie, dite arrière 51, placée à l'arrière du compartiment central de la partie avant reçoit horizontalement les seize cartes horizontales 1.

Ces deux parties 50 et 51 sont séparées par la carte d'interface 7 qui occupe tout le fond de la partie avant 50, interconnecte les cartes verticales et horizontales et assure la distribution des signaux à ces cartes.

Dans la partie arrière 51, les deux côtés latéraux du châssis présentent chacun seize paires de fenêtres telles que 52, 53 en correspondance avec les seize cartes horizontales 1, comme sur le seul côté latéral visible dans cette figure. C'est à travers ces fenêtres que sont connectées aux cartes horizontales les fiches 28 terminant les cordons 29 de raccordement aux 256 circuits bidirectionnels. Ces fiches assurent aussi l'immobilisation des cartes horizontales dans la partie arrière; elles peuvent être retenues par vis chacune sur le connecteur correspondant 26 porté par la carte horizontale.

A l'arrière de la partie avant 50, les parties latérales de la carte d'interface qui font saillie sur la partie arrière 51 reçoivent les liaisons de sortie du boîtier-filtre 45 et les connecteurs tels que 49 de la figure 2, mais non visibles dans cette figure 3.

Un tel châssis constituera l'un des équipements d'un bâti de commutation, qui comportera, en outre, pour un réseau traitant les 256 circuits bidirectionnels, huit autres châssis chacun de seize cartes de jonction traitant chacune deux circuits bidirectionnels. Ces huit autres châssis dits de jonction, pour les 256 circuits, sont donc reliés au châssis de commutation, selon la figure 3, par 64 cordons de huit paires coaxiales, tels que 29, tous de même longueur.

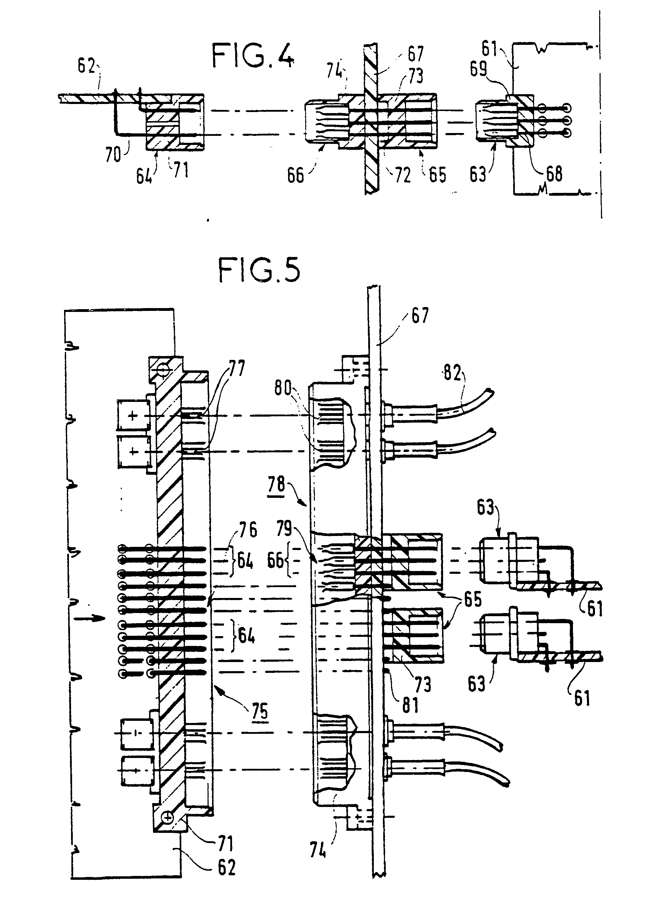

Dans la figure 4, on a illustré une partie élémentaire d'interconnexion, montée entre une carte horizontale 61 et une carte verticale 62. Cette partie élémentaire constitue une variante par rapport à celle illustrée en perspective dans la figure 1.

Cette partie élémentaire d'interconnexion définit également quatre prises multiples 63, 64, 65 et 66 portées pour deux d'entre elles, 63 et 64, par la carte horizontale 61 et la carte verticale 62, respectivement, et montées sur leurs bords en vis-à-vis et pour les deux autres 65 et 66, par une carte d'interface 67, sur l'une et l'autre de ses deux faces.

Dans cette figure 4, les prises 63 et 64 sur la carte horizontale et sur la carte verticale sont différentes l'une de l'autre, l'une est de type femelle et l'autre de type mâle.

Il en est de même des prises 65 et 66 d'enfichage des deux prises précédentes, respectivement, qui sont portées par la carte d'interface.

La prise multiple 63 portée par la carte horizontale est de type femelle. Elle a six éléments de contact 68 ayant des premières extrémités coudées, agencées en deux rangées parallèles au bord de la carte 61 et raccordées à la carte 61. Les secondes extrémités de ces éléments de contact sont internes à une embase individuelle 69 qui les entoure, elles y définissent six paires de branches à contact par pression sur des broches individuelles, agencées, vues en coupe, pour quatre d'entre elles selon les sommets d'un carré et pour les deux autres selon les milieux de deux côtés opposés de ce carré qui sont parallèles à la carte 61. Cette prise 63 est analogue à la prise 3 de la figure 1.

La prise multiple 64 portée par la carte verticale 62 est de type mâle. Elle a six éléments de contact 70 ayant des premières extrémités coudées raccordées à la carte 62, en étant agencées en deux rangées parallèles à son bord. Les secondes extrémités de ces éléments de contact forment des broches dans une embase 71 les protégeant sur deux côtés opposés et assurant un guidage à l'enfichage sur la prise 66. Dans la prise 64 quatre des broches sont, vues en coupe, selon les sommets d'un carré identique à celui défini dans la prise 63, les deux autres sont selon les milieux des deux côtés du carré parallèles à la carte 62.

La prise multiple 65 portée par la face de la carte d'interface 67 en vis-à-vis de la prise multiple 63 est de type mâle. Celle 66 portée par la face de la carte d'interface 67 en vis-à-vis de la prise multiple 64 est de type femelle. Chacune de ces prises a huit éléments de contact 72 traversant la carte d'interface. Ils définissent dans la prise 65 huit broches dans une embase individuelle 73 qu'elles traversent à force et dans la prise 66 un ensemble de huit paires de branches de contact à pression protégé sur deux côtés par une embase 74. Dans les prises 65 et 66, les éléments de contact sont, vus en coupe, selon les sommets d'un carré identique à celui défini dans les prises 63 et 64 et selon les milieux des côtés de ce carré.

Les prises 65 et 66 peuvent comporter un neuvième élément de contact, disposé, en coupe, selon le centre du carré; l'une et/ou l'autre des prises 63 et 64 peuvent également comporter un élément de contact supplémentaire correspondant.

Fonctionnellement cette partie élémentaire d'interconnexion est identique à celle de la figure 1. Par les quatre éléments de contact aux sommets des carrés, elle assure les liaisons entre les cartes 61 et 62; par les autres éléments de contact, elle assure la distribution de signaux à la carte 61 et à la carte 62 et éventuellement le prélèvement de signaux de ces cartes à partir d'un réseau de pistes conductrices non représenté de la carte d'interface qui est relié aux éléments de contact des milieux des côtés du carré.

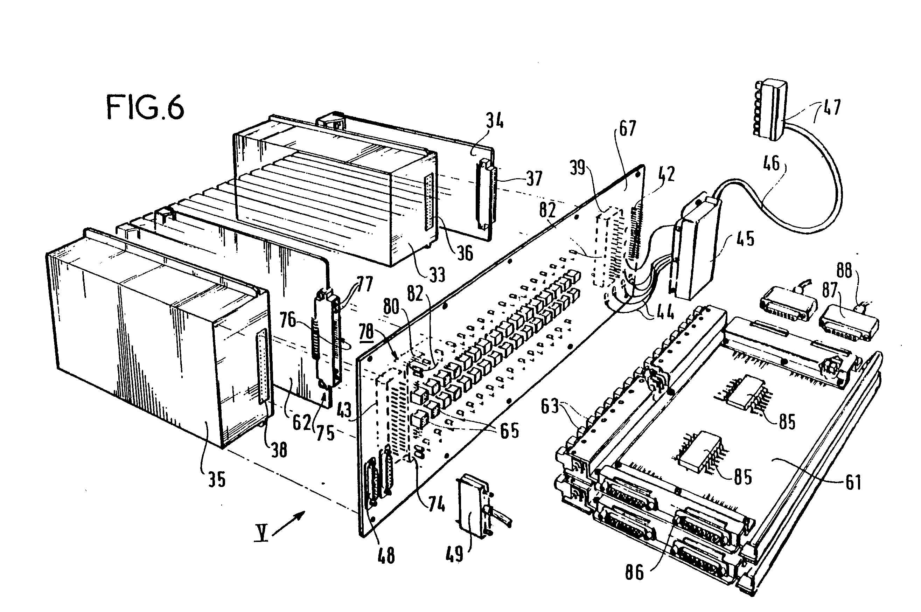

Dans les figures 5 et 6 on a illustré un ensemble d'interconnexion entre cartes orthogonales désignées par les références 61 et 62 précitées. Dans cet ensemble d'interconnexion on retrouve, pour la majorité d'entre eux, les éléments de la figure 4, ils sont désignés par les mêmes références.

Les cartes telles que 61 et 62 appartiennent à deux empilages, les cartes horizontales 61 sont en nombre restreint, ici de deux; les cartes verticales sont au nombre de seize.

Dans ces conditions, avantageusement les prises 64, 65 et 66 sont définies dans des connecteurs de type existant, adaptés en conséquence.

Ainsi, chacune des cartes verticales 62 porte un connecteur mixte 75 de type mâle, qui présente de manière connue dans la partie centrale de son embase désignée par la référence 71 précitée des logements pour broches 76 agencés en trois rangées parallèles. Il a à chacune des deux extrémités de son embase deux contacts coaxiaux 77 montés dans des logements spéciaux prévus dans l'embase et raccordés à la carte 62. La seule adaptation sur ce connecteur 75 pour définir les prises précitées 64, peut consister à n'équiper de broches que les logements des deux rangées parallèles extrêmes dans la partie centrale de son embase de manière à former deux rangées de broches auxquelles correspondent deux rangées de trous métallisés le long du bord de la carte 62, pour leur raccordement.

La carte d'interface 67 porte autant de connecteurs mixtes 78 qu'il y a de cartes verticales, les connecteurs 78 sont chacun complémentaire du connecteur 75 et au même pas que les cartes verticales dans leur empilage. Chaque connecteur 78, monté sur la face de la carte d'interface 67 en vis-à-vis des cartes verticales, est de type femelle. Il a dans la partie centrale de son embase, désignée par la référence 74 précitée, trois rangées de contacts femelles à pression terminant un jeu de broches 79 qui traversent à force la carte d'interface. Il a à chacune des deux extrémités de son embase deux contacts coaxiaux 80 correspondant aux contacts coaxiaux 77.

Sur la face de la carte d'interface en vis-à vis des deux cartes horizontales, les deux prises 65 affectées dans chaque connecteur 78 aux deux cartes horizontales sont définies. Pour adapter en conséquence chaque connecteur 78, les broches, autres que les huit ou neuf broches appartenant à l'une ou l'autre des deux prises 65, sont sectionnées sous forme de contacts courts 81. Les embases individuelles 73 montées à force sur l'un et l'autre des deux groupes de broches conservées "matérialisent" les prises 65 et protègent leurs broches. Sur cette même face de la carte d'interface, les contacts coaxiaux 80 sont raccordés à des liaisons coaxiales 82 telles que celles représentées.

Chacune des deux cartes horizontales 61 porte une réglette de prises multiples identiques 63. Cette réglette est analogue à la réglette 30 de l'agencement selon la figure 2 et n'est donc pas décrite.

Dans cet ensemble d'interconnexion, les seules adaptations des connecteurs existants 75 et 78 mentionnées ci-avant suffisent à l'établissement des connexions précitées entre chaque carte verticale et chaque carte horizontale et des liaisons précitées entre la carte d'interface et chacune des cartes horizontales et verticales pour la distribution de signaux à ces cartes et éventuellement le prélèvement de signaux de ces cartes. Pour cette distribution de signaux à partir de la carte d'interface 67, dans la figure 6, on voit que cette carte d'interface 67 est aussi équipée de connecteurs analogues à ceux portés par la carte 7 montrée dans la figure 2. Ces connecteurs, qui permettent l'application des divers signaux d'alimentation d'horloge et de test notamment, et les circuits ou éléments auxquels ils sont raccordés ne sont plus décrits en regard de cette figure 6, ils sont simplement repérés par les références qui les désignent dans la figure 2.

L'ensemble d'interconnexion tel qu'illustré dans cette figure 6 permet avantageusement l'interconnexion entre cartes de jonction et cartes de circuit de commutation, en particulier au niveau des étages d'extrémité, dans un réseau de commutation entre circuits bidirectionnels à étages de sélection en cascade, par exemple entre 2048 circuits bidirectionnels.

Les cartes verticales 62 précitées sont des cartes de jonction traitant chacune deux circuits bidirectionnels. Elles sont chacune reliées par les contacts coaxiaux 77 qu'elles portent et ceux 80 de la carte d'interface à ces deux circuits bidirectionnels.

Dans l'exemple considéré, seize cartes verticales de jonction sont empilées et interconnectées à deux cartes horizontales 61 qui portent chacune deux circuits de commutation schématisés en 85. Les quatre circuits de commutation de l'ensemble des deux cartes réalisent la fonction de quatre matrices 16x16 utilisées de manière symétrique dans le réseau de commutation pour l'un et l'autre des sens de transmission entre les circuits bidirectionnels concernés. Sur chaque carte horizontale 61 la réglette de prises 63 définit seize accès bidirectionnels interconnectés aux seize cartes de jonction. Sur les cartes horizontales 61, les circuits de commutation 85 définissent, avec un réseau de raccordement non illustré s'étendant sur les deux cartes 61 avec des liaisons d'une carte à l'autre, des chemins de liaison possibles entre les trente deux accès bidirectionnels formés par les prises 63 des deux cartes et trente deux autres accès bidirectionnels répartis sous forme de huit connecteurs 86 à raison de quatre par carte, chacun à huit contacts coaxiaux. Les quatre connecteurs 86 de chaque carte 61 sont portés par les bords de cette carte adjacents à celui portant la réglette de prises 63. Les seize cartes de jonction et les deux cartes de commutation qui leur sont interconnectées constituent un module d'extrémité. Huit fiches telles que 87 terminant huit cordons 88 de huit paires coaxiales chacun permettent le raccordement de ce module d'extrémité aux accès de modules d'étage de sélection adjacents.

Ce module d'extrémité dans un réseau de commutation, est en pratique monté en châssis, analogue à celui de la figure 3 et non représenté pour cette raison.

Pour la constitution d'un réseau complet de commutation entre 2048 circuits bidirectionnels, l'équipement est monté en huit bâtis comportant, de manière identique, chacun huit châssis de module d'extrémité traitant chacun trente deux circuits bidirectionnels et un châssis selon la figure 3 traitant 256 circuits bidirectionnels, dans l'ensemble des huit bâtis, chacun des soixante-quatre châssis de module d'extrémité étant relié à chacun des huit châssis selon la figure 3 par un cordon de huit paires coaxiales, ces cordons étant tous de même longueur. Des réseaux de commutation entre 512 ou 1024 circuits bidirectionnels peuvent être réalisés de manière analogue à celui traitant 2048 circuits, par adaptation convenable des circuits portés par les cartes de commutation 61 précédentes.

**Revendications**

1. Ensemble d'interconnexion de cartes de circuits imprimés orthogonales d'un premier empilage et d'un second empilage, respectivement, comportant des premiers éléments de contact montés sur les bords en vis-à-vis desdites cartes dans leurs deux empilages et affectés aux liaisons entre cartes, et une carte de circuits imprimés supplémentaire, dite carte d'interface, montée perpendiculairement auxdites cartes, entre les deux empilages, caractérisé en ce qu'il comporte, en outre, des seconds éléments de contact (12) montés sur les mêmes bords en vis-à-vis desdites cartes, et définissant avec lesdits premiers éléments de contact (11) une série de premières prises multiples à enfichage (3; 63) le long du bord concerné de chacune desdites cartes (I; 61) du premier empilage et une série de secondes prises multiples à enfichage (4; 64) le long du bord concerné de chacune desdites cartes (2; 62) du second empilage, et en ce que ladite carte d'interface (7; 67) porte d'une part, un réseau de pistes conductrices (8) affecté à la distribution de signaux auxdites cartes et dit réseau de distribution et, d'autre part, des troisièmes éléments de contact (15) dits de liaison et des quatrièmes éléments de contact (16) dits de distribution et reliés audit réseau de distribution, montés transversalement à ladite carte d'interface en définissant, sur une première de ses faces, un ensemble de troisièmes prises multiples (5; 65) d'enfichage desdites premières prises (3; 63) et, sur la deuxième de ses faces, un ensemble de quatrièmes prises multiples (6; 66) d'enfichage desdites secondes prises (4; 64), assurant la connexion entre les premiers éléments desdites premières et secondes prises correspondantes à travers lesdits éléments de liaison et la connexion desdits seconds éléments de contact de chacune desdites cartes audit réseau de distribution à travers lesdits éléments de distribution.

2. Ensemble d'interconnexion selon la revendication 1, caractérisé en ce que, dans lesdites prises, les éléments de contact (11, 15) affectés aux liaisons entre lesdites cartes orthogonales sont au nombre de quatre et, vus en coupe selon un plan parallèle à la carte d'interface, agencés entre eux selon les sommets d'un carré ayant, pour lesdites premières et secondes prises (3, 4; 63, 64), deux de ses côtés parallèles auxdites cartes.

3. Ensemble d'interconnexion selon la revendication 2, caractérisé en ce que, dans lesdites premières et secondes prises (3, 4; 63, 64), les seconds éléments de contact (12) sont au nombre de deux, et opposés l'un à l'autre dans la prise concernée et, dans lesdites troisièmes et quatrièmes prises (5, 6; 65, 66), les éléments de contact dits de distribution (16) au nombre de quatre et deux à deux opposés dans la prise concernée.

4. Ensemble d'interconnexion selon la revendication 3, caractérisé en ce que lesdits seconds éléments de contact (12) sont, vus en coupe selon un plan parallèle à la carte d'interface, agencés selon les milieux des deux côtés dudit carré parallèles à la carte correspondante.

5. Ensemble d'interconnexion selon l'une des revendications 1 à 4, caractérisé en ce que chacune desdites prises (3, 4, 5, 6) a son embase individuelle (9, 10) protégeant les éléments de contact appartenant à ladite prise.

6. Ensemble d'interconnexion selon la revendication 5, caractérisé en ce que les embases (9) desdites premières et secondes prises comportent des premiers moyens (19) de positionnement individuel desdites prises le long du bord de chacune desdites cartes qui les reçoit et des seconds moyens (21) de maintien desdites prises alignées.

7. Réseau de commutation matriciel entre circuits bidirectionnels, à étages de sélection en cascade chacun défini par un empilage de cartes portant un circuit de commutation et dites de commutation, mettant en oeuvre ledit ensemble d'interconnexion entre cartes orthogonales de deux empilages selon l'une des revendications 2 à 6, caractérisé en ce que, pour un réseau à trois étages de sélection ayant une symétrie au niveau de l'étage central, chacune des cartes (1) dudit premier empilage est affectée aux premier et troisième étages de sélection et porte, outre lesdites premières prises multiples (3), des accès bidirectionnels pour autant de couples de paires coaxiales qu'il y a de premières prises multiples, lesdits accès étant montés sous forme de connecteurs coaxiaux (26) sur les bords de la carte considérée adjacents à celui portant lesdites premières prises (3).

8. Réseau de commutation selon la revendication 7, caractérisé en ce que ladite carte d'interface (7) de l'ensemble d'interconnexion est en outre équipée de connecteurs auxiliaires (39, 42, 48) reliés audit réseau de distribution qu'elle porte, affectés à l'application de signaux sur le réseau de distribution.

9. Réseau de commutation matriciel entre circuits bidirectionnels à étages de sélection en cascade chacun défini par un empilage de cartes portant un circuit de commutation et dites de commutation, mettant en oeuvre l'ensemble d'interconnexion entre cartes orthogonales de deux empilages selon les revendications 1 à 5, caractérisé en ce que ledit ensemble d'interconnexion est utilisé entre des cartes de commutation (61) constituant les cartes du premier empilage et appartenant aux étages d'extrémité du réseau et des cartes dites de jonction (62) constituant les cartes du second empilage et traitant les circuits bidirectionnels auxquels sont affectées les cartes de commutation constituant le premier empilage.

10. Réseau de commutation matriciel selon la revendication 9, caractérisé en ce que les prises multiples (64) portées par les cartes de jonction (62) sont constituées dans des connecteurs mixtes (75), à broches (76) et contacts coaxiaux (77), et les troisièmes et quatrièmes prises multiples (65, 66) portées par la carte d'interface (67) de l'ensemble d'interconnexion dans des connecteurs mixtes complémentaires (78), à broches (79) et contacts coaxiaux (80), montés sur la face en regard des cartes de jonction et ayant ses broches (81), autres que celles définissant lesdits éléments de liaison et de distribution, escamotées, et en ce que les contacts coaxiaux (80) sur ladite carte d'interface (67) constituent des accès pour lesdits circuits bidirectionnels.

11. Réseau de commutation selon la revendication 10, caractérisé en ce que ladite carte d'interface (67) de l'ensemble d'interconnexion est en outre équipée de connecteurs auxiliaires (39, 42, 48) reliés audit réseau de distribution qu'elle porte, affectés à l'application de signaux sur le réseau de distribution.

**Patentansprüche**

1. Verbindungsbaugruppe für zueinander orthogonale Druckschaltungsplatten eines ersten und eines zweiten Stapels, mit ersten Kontaktelementen, die an den einander gegenüberstehenden Rändern der Karten in den beiden Stapeln befestigt und für die Verbindungen zwischen den Platten bestimmt sind, und mit einer zusätzlichen Druckschaltungsplatte, Zwischenplatte genannt, die zwischen den beiden Stapeln senkrecht zu den Platten montiert ist, dadurch gekennzeichnet, daß weiter zweite Kontaktelemente (12) vorgesehen sind, die an den selben einandergegenüberstehenden Rändern der Platten befestigt sind und mit den ersten Kontaktelementen (11) eine Reihe von ersten Mehrfachsteckverbindern (3; 63) entlang des betreffenden Randes jeder der Platten (1; 61) des ersten Stapels und eine Reihe von zweiten Mehrfachsteckverbindern (4; 64) entlang des betreffenden Randes jeder der Platten (2; 62) des zweiten Stapels definieren, und daß die Zwischenplatte (7; 67) einerseits ein Verteilnetz aus Leiterbahnen (8), das der Verteilung von Signalen an die Platten dient, und andererseits dritte Kontaktelemente (15), Verbindungselemente genannt, sowie vierte Kontaktelemente (16), Verteilerelemente genannt, trägt, welche mit dem Verteilnetz verbunden, quer zur Zwischenplatte montiert sind und auf einer ersten Seite einen Satz von dritten Mehrfachsteckverbindern (5; 65) zum Einstecken der ersten Mehrfachsteckverbinder (3; 63), und auf der zweiten Seite einen Satz von vierten Mehrfachsteckverbindern (6; 66) zum Einstecken der zweiten Mehrfachsteckverbinder (4; 64) definieren, welche die Verbindung zwischen den ersten Elementen der entsprechenden ersten und zweiten Mehrfachsteckverbinder über die Verbindungselemente, sowie die Verbindung der zweiten Kontaktelemente jeder der Platten mit dem Verteilnetz über die Verteilerelemente bewirken.

2. Verbindungsbaugruppe nach Anspruch 1, dadurch gekennzeichnet, daß in den Mehrfachsteckverbindern für die Verbindungen zwischen den orthogonalen Platten vier Kontaktelemente (II, 15) vorhanden sind, die, in der Schnittansicht entlang einer Parallelebene zur Zwischenplatte gesehen, zueinander an den Spitzen eines Quadrates angeordnet sind, bei dem bezüglich der ersten und zweiten Mehrfachsteckverbinder (3, 4; 63, 64) zwei seiner Seiten parallel zu den Platten verlaufen.

3. Verbindungsbaugruppe nach Anspruch 2, dadurch gekennzeichnet, daß in den ersten und zweiten Mehrfachsteckverbindern (3, 4; 63, 64) zwei zweite Kontaktelemente (12) vorhanden sind, die in dem betreffenden Mehrfachsteckverbinder einander gegenüberliegen, und daß in den dritten und vierten Mehrfachsteck verbindern (5, 6; 65, 66) vier Verteilerelemente (16) vorhanden sind, die in dem betreffenden Mehrfachsteckverbinder paar weise einander gegenüberstehen.

4. Verbindungsbaugruppe nach Anspruch 3, dadurch gekennzeichnet, daß die zweiten Kontaktelemente (12), in der Schnittansicht entlang einer Parallelebene zur Zwischenplatte gesehen, in der Mitte der beidens parallel zur entsprechenden Platte liegenden Seiten des Quadrat angeordnet sind.

5. Verbindungsbaugruppe nach einem der Ansprüche 1 bis 4, dadurch gekennzeichnet, daß jeder der Mehrfachsteckverbinder (3, 4, 5, 6) seinen eigenen Sockel (9, 10) besitzt, welcher die zu dem Verbinder gehörenden Kontaktelemente schützt.

6. Verbindungsbaugruppe nach Anspruch 5, dadurch gekennzeichnet, daß die Sockel (9) der ersten und zweiten Mehrfachsteckverbinder erste Mittel (19) zur individuellen Positionierung der Mehrfachsteckverbinder entlang des Randes jeder Platte aufweist, die sie trägt, sowie zweite Mittel (21), um die Mehrfachsteckverbinder in der Flucht zu halten.

7. Matrixförmiges Schaltnetz zwischen bidirektionalen Schaltkreisen, mit in Kaskaden geschalteten Wahlstufen, die je durch einen Stapel von sog. Schaltplatten definiert sind, die ein Schaltnetz tragen, das die Gesamtheit der Schaltverbindungen zwischen den orthogonalen Platten von zwei Stapeln herstellt, nach einem der Ansprüche 2 bis 6, dadurch gekennzeichnet, daß für ein Netz mit drei Wahlstufen und symmetrischer Ausprägung bezüglich der mittleren Stufe jede Platte (1) des ersten Stapels der ersten und dritten Wahlstufe zugeteilt ist und zu sätzlich zu den ersten Mehrfachsteckverbindern (3) bidirektionale Anschlüsse an ebenso viele koaxiale Verbindungen trägt, als es erste Mehrfachsteckverbinder (3) gibt, wobei die Anschlüsse in Form von Koaxialanschlüssen (26) an den Rändern derjenigen in Frage kommenden Platte montiert sind, die derjenigen mit den ersten Mehrfachsteckverbindern (3) benachbart ist.

8. Schaltnetz nach Anspruch 7, dadurch gekennzeichnet, daß die Zwischenplatte (7) der Verbindungsbaugruppe weiter mit Hilfsanschlüssen (39, 42, 48) ausgestattet ist, die mit dem Verteilnetz dieser Platte verbunden sind und die dem Anlegen von Signalen an das Verteilnetz dienen.

9. Matrixförmiges Schaltnetz zwischen zwei bidirektionalen Schaltungen mit in Kaskaden geschalteten Wahlstufen, die je durch einen Stapel von sog. Schaltplatten definiert sind, die ein Schaltnet tragen, das die Gesamtheit der Schaltverbindungen zwischen den orthogonalen Platten von zwei Stapeln herstellt, nach den Ansprüchen 1 bis 5, dadurch gekennzeichnet, daß die Verbindungsbaugruppen zwischen Schaltplatten (61), welche die Platten des ersten Stapels bilden und den Endstufen des Netzes angehören, und den sog. Übergangsplatten (62) ver wendet wird, welche die Platten des zweiten Stapels bilden und die bidirektionalen Schaltungen bedienen, denen die den ersten Stapel bildenden Schaltplatten zugeteilt sind.

10. Matrixförmiges Schaltnetz nach Anspruch 9, dadurch gekennzeichnet, daß die von den Übergangsplatten (62) getragenen Mehrfachsteckverbinder (64) in Hybridsteckverbindern (78) ausgebildet sind, die Kontaktstifte (76) und Koaxialkontakte (77) aufweisen, und daß die dritten und vierten Mehrfachsteckverbinder (65, 66), die sich auf der Zwischenplatte (67) der Verbindungsbaugruppe befinden, in komplementären Hybridsteckverbindern (78) ausgebildet sind, die Kontaktstifte (79) und Koaxialkontakte (80) aufweisen, welche auf der Seite gegenüber den Übergangsplatten montiert sind, wobei ihre Stifte (81), mit Ausnahme der die genannten Verbindungs- und Verteilerelemente definierenden Stifte, versenkt sind, und daß die Koaxialkontakte (80) auf der Zwischenplatte (67) Anschlüsse an die bidirektionalen Schaltungen bilden.

11. Schaltnetz nach Anspruch 10, dadurch gekennzeichnet, daß die Zwischenplatte (67) der Verbindungsbaugruppe weiter mit Hilfssteckverbindern (39, 42, 48) ausgestattet ist, die mit dem von ihr getragenen Verteilnetz verbunden sind und dem Anlegen von Signalen an das Verteilnetz dienen.

## Claims

1. An interconnection assembly for orthogonal printed circuit boards, respectively of a first and a second stack, comprising first contact members mounted on respectively facing edges of said boards in their two stacks and assigned to the connections between boards, and a supplementary printed circuit board, referred to as interface board, mounted perpendicular to said boards between the two stacks, characterized in that the assembly further comprises second contact members (12) mounted on the same facing edges of said boards and defining with said first contact members (11) a series of first multiple plug-in connectors (3; 63) along the concerned edge of each board (1; 61) of the first stack, and a series of second multiple plug-in connectors (4; 64) along the concerned edge of each board (2; 62) of the second stack, and that said interface board (7; 67) carries, on the one hand, an array of conducting tracks (8) assigned to distribute signals to said boards and referred to as distribution networks, and on the other hand, third contact members (15), referred to as linking members, and fourth contact members (16), referred to as distribution members, and connected to said distribution network, mounted transversely to said interface board and defining on one side thereof a set of third multiple plug-in connectors (5; 65) for said first connectors (3; 63), and on the other side thereof a set of fourth multiple plug-in connectors (6; 66) for said second connectors (4; 64) adapted to ensure the connection between the first members of said first and second corresponding connectors via said linking members, and the connection between said second contact members of each board and said distribution network via said distribution members.

2. An interconnection assembly according to claim 1, characterized in that in said connectors there are four contact members (II, 15) assigned to the connections between said orthogonal boards and arranged as seen in cross-section in a plane parallel to the interface board, at the corners of a square having, in the case of said first and second connectors (3, 4; 63, 64) two sides parallel to said boards.

3. An interconnection assembly according to claim 2, characterized in that in said first and second connectors (3, 4; 63, 64) there are two second contact members (12), in opposed relation to each other in the connector concerned, and that in said third and fourth connectors (5, 6; 65, 66) there are four distribution contact members arranged in opposed pairs in the connectors concerned.

4. An interconnection assembly according to claim 3, characterized in that said second contact members (12) are, as seen in cross-section in a plane parallel to said interface board, disposed at the centers of the two sides of said square parallel to the corresponding board.

5. An interconnection assembly according to anyone of claims 1 to 4, characterized in that each connector (3, 4, 5, 6) comprises an individual collar (9, 10) to protect the contact members of the connector.

6. An interconnection assembly according to claim 5, characterized in that said collars (9) of said first and second connectors comprise first means (19) for individually positioning said connectors along the edge of each of said boards receiving them, and second means (21) for holding said connectors in alignment.

7. A matrix switching network between bidirectional circuits including cascaded selection stages each defined by a stack of switching circuit boards, referred to as switching boards, implementing said interconnection assembly for orthogonal boards of two stacks according to one of the claims 2 to 6, characterized in that, for a network including three selection stages which is symmetrical with respect to the center stage, each board (1) of said first stack is assigned to said first and third selection stages and carries, in addition to said third multiple connectors (3), bidirectional accesses for as many pairs of coaxial couplings as there are first multiple connectors, said accesses being mounted as coaxial connectors (26) on the edges of the considered board adjacent to the board carrying said first connectors (3).

8. A switching network according to claim 7, characterized in that said interface board (7) of said interconnection assembly is further equipped with auxiliary connectors (39, 42, 48) connected to said distribution network that it carries and assigned to apply signals to said distribution network.

9. A matrix switching network between bidirectional circuits including cascaded selection stages each defined by a stack of switching circuit boards, referred to as switching boards, implementing an interconnection assembly of orthogonal boards of two stacks, according to claims 1 to 5, characterized in that said interconnection assembly is employed between switching boards (61) constituting the boards of the first stack and belonging to the terminal stages of the network, and boards, referred to as junction boards (62), constituting the boards of the second stack and processing bidirectional circuits to which are assigned the switching boards constituting the boards of said first stack.

10. A matrix switching network according to claim 9, characterized in that said multiple connectors (64) carried by the junction boards (62) consist of hybrid connectors (75) with pins (76) and coaxial contacts (77) and said third and fourth multiple connectors (65, 66) carried by said interface board (67) of said interconnection assembly consist of complementary hybrid connectors (78) with pins (79) and coaxial contacts (80), mounted on the facing edge of the junction boards and having hidden those of their pins (81) which do not define said linking and distribution members, and that said coaxial contacts (80) on said interface board (67) constitute accesses for said bidirectional circuits.

11. A switching network according to claim 10, characterized in that said interface board (67) of the interconnection assembly is further equipped with auxiliary connectors (39, 42, 48) connected to said distribution network that it carries and assigned to apply signals to said distribution network.

FIG.1

EP 0 220 677 B1

FIG.2

EP 0 220 677 B1

FIG.3

# FIG.4

# FIG.5

FIG.6